# EUROPEAN PATENT SPECIFICATION

(11) **EP 4 272 251 B1**
(45) Date of publication and mention of the grant of the patent: **20.08.2025**
(21) Application number: 22718193.0
(22) Date of filing: 25.03.2022
(51) Int. Cl.: H01L 23/473, H01L 25/07, H01L 25/11, H05K 7/20

(54) **POWER DEVICE AND METHOD FOR ASSEMBLING A POWER DEVICE**
LEISTUNGSVORRICHTUNG UND VERFAHREN ZUR MONTAGE EINER LEISTUNGSVORRICHTUNG
DISPOSITIF D'ALIMENTATION ET PROCÉDÉ D'ASSEMBLAGE DE DISPOSITIF D'ALIMENTATION

(43) Date of publication of application: 08.11.2023
(73) Proprietor: Hitachi Energy Ltd, 8050 Zürich (CH)
(72) Inventor: MALEKI, Milad, 5417 Untersiggenthal (CH); SANTOLARIA, Lluis, 4600 Olten (CH)
(74) Representative: Epping - Hermann - Fischer
(86) International application number: PCT/EP2022/057963
(87) International publication number: WO 2023/179873

(56) References cited:
- WO-A1-2021/124922

## Description

The present disclosure relates to a power device and a method for assembling a power device.

Power devices, such as inverters, are widely known. They usually comprise several power semiconductor modules mounted on one side of a carrier for e.g. liquid or air cooling. The power semiconductor modules may be arranged in a row on the top side of the carrier so that a serial cooling can be provided.

Document WO 2021/124922 A1 discloses an electric power conversion device that can achieve downsizing while ensuring cooling performance. A first circuit body having a first heat radiation surface and a second circuit body having a second heat radiation surface are positioned at a first side of a cooling flow path and a third circuit body having a third heat radiation surface is positioned at an opposite side of the refrigerant flow path. Each of the circuit bodies comprises a frame body fixed to the flow path forming body by screws.

There is a need for an improved power device, e.g. for a power device with good thermal properties and a compact design with reduced area and/or space consumption. Furthermore, there is a need for a method of assembling such a power device.

The invention relates to a power device according to claim 1. The invention relates to a method according to claim 9.

Embodiments of the disclosure relate to an improved power device. Other embodiments of the disclosure relate to a method for assembling a power device. The invention, however, is defined in the claims. Therefore, portions of the description and drawings relating to embodiments not covered by the claims are not presented as embodiments of the invention, but as examples useful in understanding the invention.

Firstly, the power device is specified.

According to an embodiment, the power device comprises at least two power semiconductor modules and a carrier having a top side and an opposite bottom side. The power semiconductor modules are mounted on the carrier and are thermally connected to the carrier. At least two power semiconductor modules are arranged in an overlapping configuration such that at least one power semiconductor module being mounted on the top side and at least one power semiconductor module being mounted on the bottom side at least partially overlap with each other when seen in plan view of the top side.

The present invention is, inter alia, based on the recognition that semiconductor power modules arranged in a row on one side of a carrier make installation and electric connection of the power semiconductor modules comparably easy. On the other hand, with the row being created by the power modules and the corresponding clamping mechanisms, the complete setup is becoming comparably long. For example, the length of the carrier may then exceed the size limit for a desired application like, **e.g.,** an application in the automotive sector where available space is limited.

The inventors of the present invention had, inter alia, the idea to arrange the power semiconductor modules on the top side and the bottom side of the carrier in an overlapping configuration in order to save space. For example, the length of the carrier can then be reduced by up to 50%.

All of the power semiconductor modules of the power device may be of the same type or may be constructed similarly. Therefore, all features disclosed herein for one power semiconductor module are also disclosed for further or all other power semiconductor modules of the power device.

The power semiconductor modules may each comprise one or more power semiconductor chips. The power semiconductor chips are, e.g., electrically, thermally and/or mechanically interconnected within the module. The power semiconductor modules may each comprise a substrate, which may have a top metallization and a bottom metallization and an insulating layer in-between. The one or more power semiconductor chips may be electrically, mechanically and/or thermally connected to the top metallization. The substrate may be a DBC (direct bonded copper) substrate or a DBA (direct bonded aluminum) substrate or an AMB (active metal bracing) substrate with isolating ceramic layer or an IMS (isolated metal substrate) with isolating resin layer, for example. Furthermore, the power semiconductor modules may each comprise terminals, which may be bonded to the top metallization.

The power semiconductor modules may each be adapted for processing currents of more than 10 A. The power semiconductor modules may be low voltage modules adapted for processing voltages below 1 kV, or may be medium voltage modules adapted for processing voltages between 1 kV and 30 kV.

The power semiconductor chips are arranged in a housing of the respective power semiconductor module. The housing is formed by an encapsulation, wherein the power semiconductor chips are embedded in said encapsulation. The encapsulation may be a resin or a dielectric gel. For instance, the encapsulation is formed by casting or molding, e.g. transfer molding. Also the substrate and/or the terminals of the power semiconductor module
may be arranged in said housing and embedded in said encapsulation.

The power semiconductor modules may further comprise a baseplate, on which the power semiconductor chips and/or the substrate are mounted. For example, the substrate is mounted on the baseplate with the bottom metallization facing the baseplate. The baseplate is, e.g., configured for dissipating heat from the power semiconductor chips. By way of example, the baseplate is formed of metal, like Cu or Al or a composite material like aluminum silicon carbide or magnesium silicon carbide.

The carrier may be a cooling carrier. For example, the carrier comprises or consists of metal, like Cu or A1. The carrier may be formed in one piece or of several pieces, e.g. two half-shells.

The power semiconductor modules arranged in the overlapping configuration may partially or completely overlap with each other when seen in plan view of the top side. In other words, when the semiconductor chips in the overlapping configuration are projected onto the top side of the carrier, the projected power semiconductor modules partially or completely overlap with each other. For example, at least 25 % or at least 30 % of the area of a semiconductor module on the top side overlaps with a power semiconductor module on the bottom side and/or vice versa. Additionally or alternatively, at most 75 % or at most 70 % of the area of a power semiconductor module on the top side may overlap with a power semiconductor module on the bottom side and/or vice versa. For example, several or each power semiconductor module of the power device mounted on one side of the carrier is arranged in an overlapping configuration with at least one other power semiconductor module on the other side of the carrier.

The power semiconductor modules of the power device are, e.g., electrically connected with each other.

The power device may comprise several power semiconductor modules mounted on the top side and/or several power semiconductor modules mounted on the bottom side. All features disclosed for one power semiconductor module on the top side are herein also disclosed for all other power semiconductor modules on the top side and all features disclosed for one power semiconductor module on the bottom side are herein also disclosed for all other power semiconductor modules on the bottom side.

Herein, the expression "top" and "bottom" or similar expressions are in no way to be understood to be restricted to directions antiparallel and parallel to the direction of gravity. They are rather used in general, e.g. to indicate areas or directions opposite to each other.

According to a further embodiment, the power device comprises at least three power semiconductor modules arranged in an overlapping configuration such that either at least two power semiconductor modules mounted on the top side overlap with at least one same power semiconductor module mounted on the bottom side when seen in plan view of the top side, or at least two power semiconductor modules mounted on the bottom side overlap with at least one same power semiconductor module mounted on the top side when seen in plan view of the top side. Each power semiconductor module may overlap with at most two power semiconductor modules when seen in plan view of the top side.

For example, in the plan view of the top side, one power semiconductor module on one side overlapping with two power semiconductor modules on the other side is arranged between the two power semiconductor modules on the other side in lateral direction, e.g. symmetrically between the two power semiconductor modules. A lateral direction is herein a direction parallel to the top side of the carrier and/or parallel to a main extension plane of the carrier.

Concerning the degree of overlap, the same as disclosed above in connection with at least two power semiconductor modules arranged in the overlapping configuration is disclosed for the at least three power semiconductor modules arranged in the overlapping configuration.

Here and in the following, all features disclosed for at least two power semiconductor modules arranged in the overlapping configuration are also disclosed for all of the power semiconductor modules arranged in an overlapping configuration.

The power semiconductor modules of the power device may be arranged in one or more rows when seen in plan view of the top side. The power semiconductor modules of one row may each be arranged in an overlapping configuration with at least one other power semiconductor module of the same row. For example, the at least one row extends in a longitudinal direction, said longitudinal direction being a lateral direction. At least one semiconductor module of a row may also overlap with a semiconductor module on the other side and of a different row when seen in plan view of the top side.

According to a further embodiment, the power semiconductor modules arranged in the overlapping configuration each comprise a plurality of cooling elements at their respective backside. The backside is the side of the power semiconductor module facing towards the carrier. The cooling elements may project from the backside towards the carrier. The backside may be formed by the baseplate or the substrate and/or the housing. The cooling elements may be formed by the baseplate or the substrate.

The carrier comprises at least one top opening at the top side. The top opening may be an opening to a cavity in the carrier. Furthermore, the carrier comprises at least one bottom opening at the bottom side. The bottom opening may be an opening to a cavity in the carrier. Each top opening and bottom opening may be assigned to an individual cavity. The individual cavities may be fluidically coupled with each other, e.g. via a channel portions. Alternatively, the top and the bottom opening may be openings to the same cavity. For example, the carrier is a hollow body with one or more cavities inside. For example, the one or more cavities each have one of a cuboid shape, a cube shape or a cylindrical shape. For instance, the cavity or cavities do not completely extend through the carrier.

The at least one top opening and the at least one bottom opening at most partially overlap with each other when seen in plan view of the top side of the carrier. For example, the top opening is arranged overlap-free with the at least one bottom opening when seen in plan view of the top side. In other words, in plan view of top side, the top opening does not overlap with the bottom opening. Alternatively, there may be a small overlap of the top and bottom opening, e.g. of at most 25 % or at most 20 % or at most 10 % of the area of the top or bottom opening.

The carrier may comprise several top openings and/or bottom openings. All features disclosed in connection with one top opening or one bottom opening are also disclosed for all other top openings and bottom openings, respectively. For example, all openings are arranged overlap-free or at most partially overlapping with each other when seen in plan view of the carrier.

The cooling elements of the power semiconductor modules arranged in the overlapping configuration project through the top opening and the bottom opening into the carrier, i.e. into an interior of the carrier, e.g. into a cavity in the carrier. This means that the cooling elements of a power semiconductor module on the top side project through the top opening and the cooling elements of a power semiconductor module on the bottom side project through the bottom opening. Each semiconductor module may be assigned either a top opening or a bottom opening on a one-to-one basis and the cooling elements may project through the assigned opening.

Due to the non-overlapping or only small-overlapping arrangement of the top opening(s) and the bottom opening(s), the carrier can be designed to be relatively thin.

According to a further embodiment, the cooling elements are cooling ribs or cooling fins, e.g. pin-fins. For example, the cooling fins have a cylindrical, conical or diamond shape.

The cooling elements may protrude columnar from the backside, i.e. main extension directions of the cooling elements may run perpendicularly to the main extension plane of the power semiconductor module.

The power semiconductor modules arranged in the overlapping configuration each comprise a functional region and an auxiliary region. The functional region may be a central region and the auxiliary region may be a peripheral region laterally surrounding the central region, e.g. laterally completely surrounding the central region. The functional region and the auxiliary region may each be contiguous regions without interruptions. In plan view of the top side, the area of the auxiliary region may be at least 10 % or at least 50 % and/or at most 100 % or at most 70 % of the area of the functional region.

One or more power semiconductor chips are arranged in the functional region of the power semiconductor module. Additionally, one or more cooling elements are arranged in the functional region.

The auxiliary region of the semiconductor module is free of semiconductor chips and/or free of cooling elements.

Each power semiconductor module may comprise several functional regions which are separated in lateral direction by the one or more auxiliary regions. All features disclosed in connection with one functional region are also disclosed for all other functional regions of the power semiconductor module. All features disclosed in connection with one auxiliary region are also disclosed for all further auxiliary regions.

According to a further embodiment, the auxiliary regions of the power semiconductor modules in the overlapping configuration overlap at least partially with each other in plan view of the top side. The functional regions of the power semiconductor modules in the overlapping configuration are, e.g., overlap-free with each other in this plan view, i.e. they do not overlap with each other in this plan view.

The functional region with the assigned power semiconductor chips is, e.g., the region where most of the heat is generated during operation. It is advantageous to arrange the functional regions overlap-free with respect to each other in order to evenly distribute the heat over the carrier and therefore to improve the cooling properties. A serial cooling is improved in this way, for instance.

According to a further embodiment, the cooling elements of the power semiconductor modules are, in each case, arranged in the functional region and outside the auxiliary region. That is, in plan view of the top side of the carrier, the cooling elements of the power semiconductor module only overlap with the functional region but not with the auxiliary region. For example, in plan view of the top side, the auxiliary region laterally completely surrounds the cooling elements and/or the opening assigned to the semiconductor module. The area occupied by the cooling elements has, e.g., at least the size of the perimeter of the arrangement of power semiconductor chips of the power semiconductor module.

The auxiliary region is configured for connecting the power semiconductor module to the carrier. In the auxiliary region, the backside of the power semiconductor module may be flat in order to allow mounting of the power semiconductor module on the carrier. At least in the auxiliary region, the backside may be formed by the substrate or the baseplate.

In the auxiliary region, the semiconductor module is fixed to the carrier by fixing means. In plan view of the top side, the fixing means only overlap with the auxiliary region. The fixing means may be one or more clamps with which the power semiconductor module is clamped onto the carrier and/or one or more screws with which the power semiconductor module is screwed onto the carrier. In the auxiliary region, one or more screw holes are formed through the power semiconductor module, e.g. through the encapsulation and/or the baseplate and/or the substrate. The fixing means assigned to a power semiconductor module, being in an overlapping configuration with another power semiconductor module, may overlap with this other power semiconductor module, e.g. with its functional region, when seen in plan view of the top side. A fixing means may be also dedicated to two neighbored power semiconductor modules on one of the top or bottom side.

According to a further embodiment, the carrier is configured to guide a cooling fluid for cooling the power semiconductor modules. The cooling fluid may be guided through the interior of the carrier, e.g. between the top side and the bottom side. For example, the carrier is configured to guide the cooling fluid within the carrier in the main extension direction of the row(s) in which the power semiconductor modules are arranged, i.e. in longitudinal direction.

The carrier may comprise an inlet for guiding the cooling fluid into the carrier and an outlet for guiding the cooling fluid out of the carrier. The cooling fluid may be gaseous or liquid. For example, the cooling fluid is water-based coolant or oil. The reduced length of the carrier allows a reduction of the length of the cooling liquid flow path. This can increase the cooling efficiency.

According to a further embodiment, the carrier is configured to guide a cooling fluid past the cooling elements projecting through the openings. Hence, the cooling fluid may then flow along and pass the cooling elements and may thereby absorb heat from the cooling elements stemming from the power semiconductor chips. The cooling elements may thereby also create turbulence in the cooling fluid, which is advantageous in terms of the cooling efficiency.

According to a further embodiment, at least one channel is formed in the carrier for guiding the cooling fluid. The channel may extend from one end of the carrier to another end of the carrier. The channel may be connected to the inlet and the outlet. For example, the channel extends from one end of the row in which the power semiconductor modules are arranged to the other end of the row. The openings at the top and bottom side may all be openings or entrances to the channel.

The one or more cavities in the carrier may be part of the channel or may form the channel. For example, the channel comprises one or more windings. The channel may be meander shaped. In directions perpendicular to the extension direction of the channel, the channel may be completely surrounded by material of the carrier.

The carrier may be a pure cooling carrier without electrical functionality. For example, during normal operation of the power device, no electric current is running through the carrier.

According to a further embodiment, at least one power semiconductor module, e.g. several or all power semiconductor modules, are bonded to the carrier. For example, the power semiconductor module is soldered or sintered or welded or glued to the carrier. In this case, the backside of the power semiconductor module may be flat.

According to a further embodiment, at least one power semiconductor module, e.g. several or all power semiconductor modules, comprise at least one power semiconductor chip being one of: an IGBT, a diode, a MOSFET, a thyristor, a JFET, a HEMT. The power semiconductor module may comprise a plurality of such power semiconductor chips.

For example, the at least one power semiconductor module comprises a plurality of power semiconductor chips connected in a half-bridge or full-bridge configuration.

A half bridge is an electrical circuit, comprising two switch elements or two pairs consisting of each one switch element and one diode, connected in series between two DC connection points and providing an AC connection point or output point in between. The DC connection points and the AC connection point / output point may be electrically connected to the power terminals of the power module. Each switch element may be composed of one or more semiconductor switches electrically connected in parallel. The switch elements are, e.g., realized by the above mentioned power semiconductor chips.

The power module may be employed in an electrical converter or inverter, which, for example, may rectify an AC voltage to be supplied to a DC link or a battery. It may also be possible that the inverter generates an AC voltage from a DC voltage to be supplied to an electrical motor, such as the motor of an electric vehicle. The electrical converter may also be a DC-DC converter. The power module may be used in automotive applications, such as electric cars, motorbikes, busses, off-road vehicles.

The power device may be an inverter or converter, e.g. for renewable energies such as wind turbines, solar power panels, tidal power plants and electric vehicles (EVs), or traction application. The power module may be realized in a so called sixpack configuration with three half-bridge power semiconductor modules representing the three phases.

Next the method for assembling a power device is specified. The method may be used for assembling the power device according to any embodiment described herein. Therefore, all features disclosed in connection with the power device are also disclosed for the method and vice versa.

According to an embodiment, the method for assembling a power device comprises mounting at least one power semiconductor module on a top side of a carrier and mounting at least one power semiconductor module on a bottom side of the carrier being opposite to the top side such that at least two power semiconductor modules are arranged in an overlapping configuration with at least one power semiconductor module on the top side and at least one power semiconductor module on the bottom side at least partially overlapping with each other when seen in plan view of the top side.

Mounting the power semiconductor modules on the carrier may be done such that the power semiconductor modules are fixedly connected to the carrier. For example, the power semiconductor modules are screwed, clamped, soldered, glued, welded or sintered to the carrier. Also any combination of these connection methods may be used.

According to a further embodiment, after mounting the power semiconductor modules on the carrier, the power semiconductor modules are electrically connected with each other and/or with other parts of the power device, like capacitors or control electronics.

Hereinafter, the power device and the method for assembling a power device will be explained in more detail with reference to the drawings on the basis of exemplary embodiments. The accompanying figures are included to provide a further understanding. In the figures, elements of the same structure and/or functionality may be referenced by the same reference signs. It is to be understood that the embodiments shown in the figures are illustrative representations and are not necessarily drawn to scale. In so far as elements or components correspond to one another in terms of their function in different figures, the description thereof is not repeated for each of the following figures. For the sake of clarity, elements might not appear with corresponding reference symbols in all figures.
Figures 1 to 3 show an exemplary embodiment of the power device in different views,
Figure 4 shows a further exemplary embodiment of the power device in a cross-sectional view,
Figure 5 shows a flowchart of an exemplary embodiment of the method for assembling a power device, and
Figure 6 shows a further exemplary embodiment of the power device in a cross-sectional view.

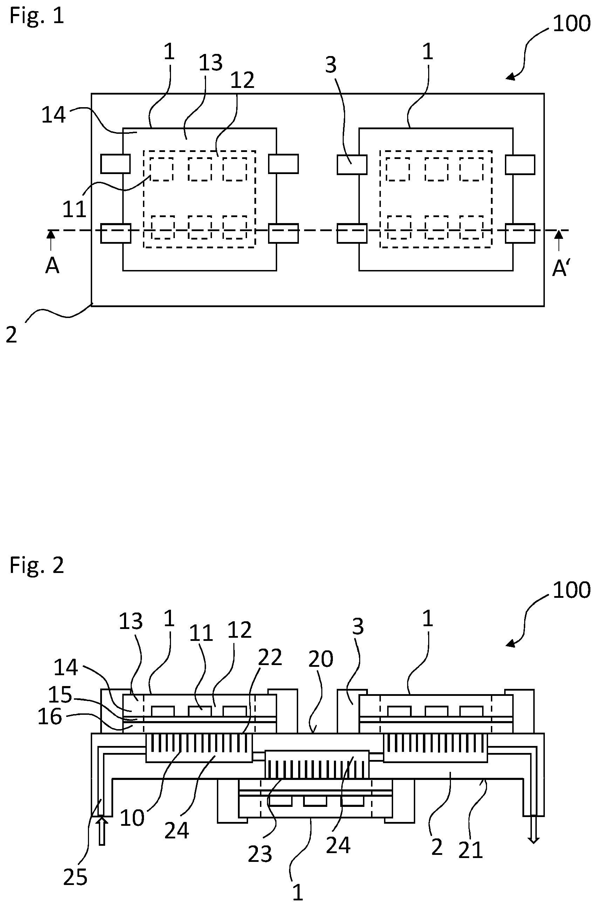

The exemplary embodiment of the power device 100 of figures 1 to 3 comprises a carrier 2 with a top side 20 and a bottom side 21. Figure 1 shows the power device 100 in plan view of the top side 20 of the carrier 2. Figure 2 shows a cross-sectional view with the cross-sectional plane running through the line AA' of figure 1.

On the top side 20 of the carrier 2, two power semiconductor modules 1 are mounted and thermally connected to the carrier 2. A third power semiconductor module 1 is mounted on the bottom side 21 of the carrier 2 and thermally connected to the carrier 2.

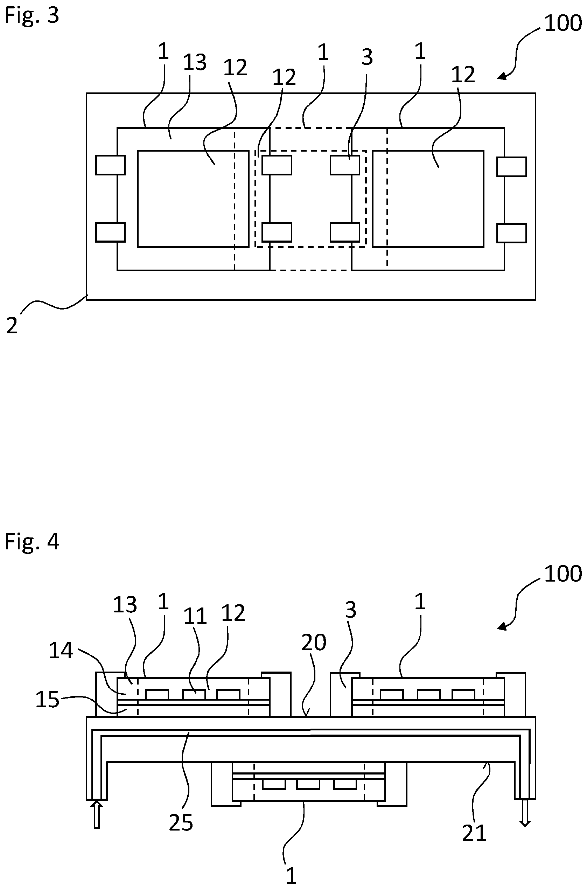

Figure 3 shows the power device 100 again in plan view of the top side of the carrier 2, but now the power semiconductor module 1 on the bottom side of the carrier 2 is indicated by dashed lines in order to illustrate the relative arrangement between all three power semiconductor modules 1.

As can be seen in the plan view of figure 3, the power semiconductor modules 1 are arranged in an overlapping configuration such that the two power semiconductor modules 1 at the top side 20 of the carrier 2 both partially overlap with the one power semiconductor module 1 on the bottom side 21 of the carrier 2. Furthermore, the power semiconductor modules 1 are arranged in a row.

The arrangement of the power semiconductor modules 1 in an overlapping configuration allows the overall length of the carrier 2 to be reduced, but still allows efficient cooling of the power semiconductor modules 1.

The power semiconductor modules 1 are fixed to the carrier 2 by means of fixing means 3. The fixing means 3 are, e.g., clamping means. The fixing means 3 are mechanically connected to the power semiconductor modules 1 in auxiliary regions 13, namely peripheral regions 13, of the power semiconductor modules 1. In each power semiconductor module 1, the peripheral region 13 laterally, i.e. in direction parallel to the top side 20, completely surrounds a functional region 12, namely a central region 12, of the power semiconductor module 1. In figures 1 and 2, the virtual border between the peripheral regions 13 and the central region 12 is indicated by a dashed line. In figure 3, the virtual border is indicated as a solid line for the power semiconductor modules on the top side and as a dashed line for the power semiconductor module on the bottom side.

The design of each power semiconductor module 1 is as follows: The central region 12 of the power semiconductor module 1 is a region in which power semiconductor chips 11 are arranged. The peripheral region 13 is free of power semiconductor chips. The power semiconductor chips 11 are, e.g., IGBTs or diodes or JFETs or MOSFETs or thyristors. The power semiconductor chips 11 are mounted on and electrically and thermally connected to a substrate 15. For example, the power semiconductor chips 11 are interconnected in a half-bridge configuration on the substrate 15. The substrate 15 is, e.g., a DBC or DBA substrate. The substrate 15 is further mounted on a baseplate 16 of the power semiconductor module 1. The baseplate 16 forms the backside of the power semiconductor module 1 and comprises a plurality of cooling elements 10 in the form of cooling ribs of cooling fins, which project from the backside towards the carrier 2.

The power semiconductor chips 11 are encapsulated in an encapsulation 14, which might be a resin. For example, the semiconductor chips 11 are molded with the encapsulation 14, e.g. by a transfer molding process.

The cooling elements 10 of the power semiconductor modules 1 are configured for cooling, namely for dissipating heat to the carrier 2. For this purpose, the carrier 2 comprises two top openings 22 at the top side 20 and one bottom opening 23 at the bottom side 21. The cooling elements 10 of the power semiconductor modules 1 on the top side 20 project through the top openings 22 into a respective cavity 24 of the carrier 2 and the cooling elements 10 of the power semiconductor module 1 on the bottom side 21 project through the bottom opening 23 into a cavity 24 of the carrier 2. As becomes apparent from figure 2, the top openings 22 and the bottom openings 23 are arranged overlap-free, i.e. they do not overlap with each other when seen in plan view of the top side 20 of the carrier 2.

As can be best seen in figure 2, the individual cavities 24 are fluidically coupled by channel portions in the carrier 2 so that a channel 25 running through the carrier 2 is formed. The channel 25 is configured for guiding a cooling fluid, like water, through the carrier 2. The channel 25 starts at an inlet and ends at an outlet. The flow direction of a cooling fluid is indicated by the arrows in figure 2. A cooling fluid can be inserted via the inlet, can flow through the channel 25, can pass the cooling elements 10 in the cavities 24 and can then leave the carrier 2 via the outlet. During this process, heat is transferred from the cooling elements 10 to the cooling fluid. The structure of the cooling elements 10 as pin-fins or ribs further creates turbulences in the cooling fluid, which is advantageous for the cooling efficiency.

Figure 4 shows a further exemplary embodiment of the power device 100. In contrast to the exemplary embodiment shown in figures 1 to 3, the power semiconductor modules 1 do not comprise cooling elements at the backside but, instead, they are each flat at the backside. The backside is again formed by a baseplate 15. For example, the power semiconductor modules 1 are soldered or sintered or glued or screwed or clamped, for example using thermal grease as thermal interface material, to the carrier 2.

The carrier 2 does not comprise openings at the top or bottom side but is flat at the top side 20 and bottom side 21. However, a cooling channel 25 is again running through the carrier 2. Heat from the power semiconductor modules 1 is transferred to the carrier 2 at the top side 20 and at the bottom side 21, respectively, and then passes through the material of the carrier 2 to the channel 25. There it is absorbed and transported away by the cooling fluid running through the channel 25.

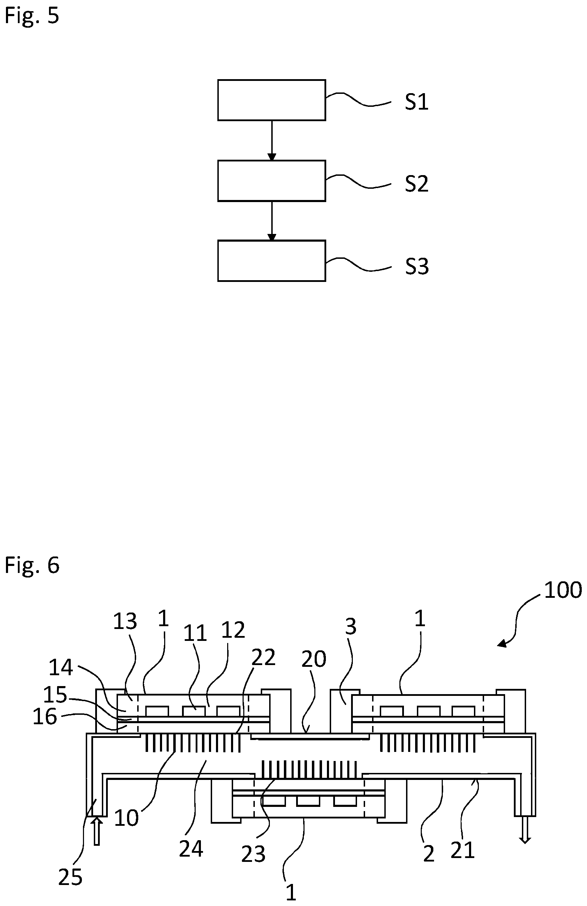

Figure 5 shows a flowchart of an exemplary embodiment of the method for assembling a power device. For example, the power device of figures 1 to 3 or of figure 4 can be produced with this method. In a step S1, at least one power semiconductor module is mounted on a top side of the carrier. In a step S2, at least one power semiconductor module is mounted on a bottom side of the carrier. At least two power semiconductor modules are thereby arranged in an overlapping configuration with at least one power semiconductor module on the top side and at least one power semiconductor module on the bottom side at least partially overlapping with each other when seen in plan view of the top side of the carrier.

In figure 6 a further exemplary embodiment of the power device 100 in cross sectional view is shown. This power device is similar to the one of figure 1 to 3. However, instead of several individual cavities 24 each uniquely assigned on top 22 or bottom 23 opening, the carrier 2 of figure 6 is a hollow body having one contiguous cavity 24. The top 22 and the bottom 23 openings are all openings or entrances, respectively, to this cavity 24. The cavity 24 is fluidically connected to the inlet and the outlet so that, with the cavity 24, a channel 25 through the carrier 2 is formed for guiding a cooling liquid.

The embodiments shown in the Figures 1 to 6 as stated represent exemplary embodiments of the power device and the method for assembling a power device. Therefore, they do not constitute a complete list of all embodiments according to the power device and the method. The invention is disclosed by the appended claims.

### Reference Signs

- 1: power semiconductor module
- 2: carrier
- 3: fixing means
- 10: cooling element
- 11: power semiconductor chip
- 12: functional/central region
- 13: auxiliary/peripheral region
- 14: encapsulation
- 15: substrate
- 16: baseplate
- 20: top side
- 21: bottom side
- 22: top opening
- 23: bottom opening
- 24: cavity
- 25: channel
- 100: power device
- S1 to S3: method steps
- A-A': cross-sectional plane

## Claims

1. Power device (100) comprising
- at least two power semiconductor modules (1),
- a carrier (2) having a top side (20) and an opposite bottom side (21), wherein
- the power semiconductor modules (1) are mounted on the carrier (2) and are thermally connected to the carrier (2),
- at least two power semiconductor modules (1) are arranged in an overlapping configuration such that at least one power semiconductor module (1) being mounted on the top side (20) and at least one power semiconductor module (1) being mounted on the bottom side (21) at least partially overlap with each other when seen in plan view of the top side (20), wherein
- the power semiconductor modules (1) arranged in the overlapping configuration each comprise a functional region (12) and an auxiliary region (13),
- one or more power semiconductor chips (11) are arranged in the functional region (12), wherein the auxiliary regions (13) of the power semiconductor modules (1) in the overlapping configuration overlap at least partially with each other in plan view of the top side (20) and the functional regions (12) are overlap-free with each other in this plan view, wherein
- the power semiconductor modules (1) each comprise a plurality of cooling elements (10) at its respective backside, the cooling elements (10) being arranged in the functional region (12),
- the carrier (2) comprises a least one top opening (22) at the top side (20) and at least one bottom opening (23) at the bottom side (21),
- the at least one top opening (22) and the at least one bottom opening (23) at most partially overlap with each other when seen in plan view of the top side (20),
- the cooling elements (10) of the power semiconductor modules (1) project through the top opening (22) and the bottom opening (23) into the carrier (2),
- the power semiconductor chips (11) are arranged in a housing of the respective power semiconductor module (1), the housing being formed by an encapsulation (14), the one or more power semiconductor chips (11) are embedded in the encapsulation (14),
- the auxiliary region (13) is free of power semiconductor chips (11),
- in the auxiliary regions (13), a backside of the power semiconductor modules (1) is formed by a substrate or a baseplate and a frontside of the power semiconductor modules (1) is formed by the encapsulation (14)
- in the auxiliary regions (13), the power semiconductor modules (12) are fixed to the carrier (2) by fixing means, wherein screw holes are formed through the encapsulation (14).

2. Power device (100) according to claim 1, wherein
- the power device (100) comprises at least three power semiconductor modules (1) arranged in an overlapping configuration such that
- at least two power semiconductor modules (1) mounted on one of the top side (20) and the bottom side (21) both overlap with at least one same power semiconductor module (1) mounted on the other one of the top side (20) and the bottom side (21) when seen in plan view of the top side (20).

3. Power device (100) according to any one of the preceding claims, wherein
- the cooling elements (10) are cooling ribs or cooling fins.

4. Power device (100) according to any one of the preceding claims, wherein
- the auxiliary regions (13) of the power semiconductor modules (1) in the overlapping configuration overlap at least partially with each other in plan view of the top side (20) and the functional regions (12) are overlap-free with each other in this plan view.

5. Power device (100) according to any one of the preceding claims, wherein
- the carrier (2) is configured to guide a cooling fluid for cooling the power semiconductor modules (1).

6. Power device (100) according to claim 5 in its dependency on claim 3, wherein
- the carrier (2) is configured to guide the cooling fluid past the cooling elements (10) projecting through the openings (22, 23).

7. Power device (100) according to claim 5 or 6, wherein
- at least one channel (25) is formed in the carrier (2) for guiding the cooling fluid.

8. Power device (100) according to any one of the preceding claims, wherein
- the power semiconductor modules (1) each comprise at least one power semiconductor chip (11) being one of: an IGBT, a MOSFET, a diode, a thyristor, a JFET, a HEMT.

9. Method for assembling a power device (100) comprising
- mounting at least one power semiconductor module (1) on a top side (20) of a carrier (2),
- mounting at least one power semiconductor module (1) on a bottom side (21) of the carrier (2) being opposite to the top side (20) such that
- at least two power semiconductor modules (1) are arranged in an overlapping configuration with at least one power semiconductor module (1) on the top side (20) and at least one power semiconductor module (1) on the bottom side (21) at least partially overlapping with each other when seen in plan view of the top side (20), wherein
- the power semiconductor modules (1) arranged in the overlapping configuration each comprise a functional region (12) and an auxiliary region (13),
- one or more power semiconductor chips (11) are arranged in the functional region (12), wherein the auxiliary regions (13) of the power semiconductor modules (1) in the overlapping configuration overlap at least partially with each other in plan view of the top side (20) and the functional regions (12) are overlap-free with each other in this plan view, wherein
- the power semiconductor modules (1) each comprise a plurality of cooling elements (10) at its respective backside, the cooling elements (10) being arranged in the functional region (12),
- the carrier (2) comprises a least one top opening (22) at the top side (20) and at least one bottom opening (23) at the bottom side (21),
- the at least one top opening (22) and the at least one bottom opening (23) at most partially overlap with each other when seen in plan view of the top side (20),
- the cooling elements (10) of the power semiconductor modules (1) project through the top opening (22) and the bottom opening (23) into the carrier (2),
- the power semiconductor chips (11) are arranged in a housing of the respective power semiconductor module (1), the housing being formed by an encapsulation (14), the one or more power semiconductor chips (11) are embedded in the encapsulation (14)
- the auxiliary region (13) is free of power semiconductor chips (11),
- in the auxiliary regions (13), a backside of the power semiconductor modules (1) is formed by a substrate or a baseplate and a frontside of the power semiconductor modules (1) is formed by the encapsulation (14)
- in the auxiliary regions (13), the power semiconductor modules (12) are fixed to the carrier (2) by fixing means, wherein screw holes are formed through the encapsulation (14).

## Patentansprüche

1. Leistungsvorrichtung (100), aufweisend:
- mindestens zwei Leistungshalbleitermodule (1),
- einen Träger (2) mit einer Oberseite (20) und einer gegenüberliegenden Unterseite (21), wobei
- die Leistungshalbleitermodule (1) auf dem Träger (2) montiert und thermisch mit dem Träger (2) verbunden sind,
- mindestens zwei Leistungshalbleitermodule (1) in einer überlappenden Konfiguration so angeordnet sind, dass sich mindestens ein Leistungshalbleitermodul (1), das auf der Oberseite (20) montiert ist, und mindestens ein Leistungshalbleitermodul (1), das auf der Unterseite (21) montiert ist, wenn in Draufsicht auf die Oberseite (20) gesehen, zumindest teilweise überlappen, wobei
- die Leistungshalbleitermodule (1), die in der überlappenden Konfiguration angeordnet sind, jeweils ein Funktionsgebiet (12) und ein Hilfsgebiet (13) aufweisen,
- ein oder mehrere Leistungshalbleiterchips (11) in dem Funktionsgebiet (12) angeordnet sind, wobei sich die Hilfsgebiete (13) der Leistungshalbleitermodule (1) in der überlappenden Konfiguration in Draufsicht auf die Oberseite (20) zumindest teilweise überlappen und die Funktionsgebiete (12) in dieser Draufsicht überlappungsfrei zueinander sind, wobei
- die Leistungshalbleitermodule (1) jeweils mehrere Kühlelemente (10) an ihrer jeweiligen Rückseite aufweisen, wobei die Kühlelemente (10) in dem Funktionsgebiet (12) angeordnet sind,
- der Träger (2) mindestens eine obere Öffnung (22) an der Oberseite (20) und mindestens eine untere Öffnung (23) an der Unterseite (21) aufweist,
- sich die mindestens eine obere Öffnung (22) und die mindestens eine untere Öffnung (23), wenn in Draufsicht auf die Oberseite (20) gesehen, höchstens teilweise überlappen,
- die Kühlelemente (10) der Leistungshalbleitermodule (1) durch die obere Öffnung (22) und die untere Öffnung (23) in den Träger (2) vorragen,
- die Leistungshalbleiterchips (11) in einem Gehäuse des jeweiligen Leistungshalbleitermoduls (1) angeordnet sind, wobei das Gehäuse durch eine Kapselung (14) gebildet ist, der eine oder die mehreren Leistungshalbleiterchips (11) in der Kapselung (14) eingebettet sind,
- das Hilfsgebiet (13) frei von Leistungshalbleiterchips (11) ist,
- in den Hilfsgebieten (13) eine Rückseite der Leistungshalbleitermodule (1) durch ein Substrat oder eine Grundplatte gebildet ist und eine Vorderseite der Leistungshalbleitermodule (1) durch die Kapselung (14) gebildet ist,
- in den Hilfsgebieten (13) die Leistungshalbleitermodule (12) durch Befestigungsmittel an dem Träger (2) befestigt sind, wobei durch die Kapselung (14) Schraubenlöcher gebildet sind.

2. Leistungsvorrichtung (100) nach Anspruch 1, wobei
- die Leistungsvorrichtung (100) mindestens drei Leistungshalbleitermodule (1) aufweist, die in einer überlappenden Konfiguration so angeordnet sind, dass
- sich mindestens zwei Leistungshalbleitermodule (1), die auf einer von der Oberseite (20) und der Unterseite (21) montiert sind, beide mit mindestens einem gleichen Leistungshalbleitermodul (1) überlappen, das auf der anderen von der Oberseite (20) und der Unterseite (21) montiert ist, wenn in Draufsicht auf die Oberseite (20) gesehen.

3. Leistungsvorrichtung (100) nach einem der vorhergehenden Ansprüche, wobei
- die Kühlelemente (10) Kühlrippen oder Kühllamellen sind.

4. Leistungsvorrichtung (100) nach einem der vorhergehenden Ansprüche, wobei
- sich die Hilfsgebiete (13) der Leistungshalbleitermodule (1) in der überlappenden Konfiguration in Draufsicht auf die Oberseite (20) zumindest teilweise überlappen und die Funktionsgebiete (12) in dieser Draufsicht überlappungsfrei zueinander sind.

5. Leistungsvorrichtung (100) nach einem der vorhergehenden Ansprüche, wobei
- der Träger (2) dazu ausgelegt ist, ein Kühlfluid zum Kühlen der Leistungshalbleitermodule (1) zu leiten.

6. Leistungsvorrichtung (100) nach Anspruch 5 in Abhängigkeit von Anspruch 3, wobei
- der Träger (2) dazu konfiguriert ist, das Kühlfluid an den Kühlelementen (10), die durch die Öffnungen (22, 23) vorragen, vorbei zu leiten.

7. Leistungsvorrichtung (100) nach Anspruch 5 oder 6, wobei
- mindestens ein Kanal (25) in dem Träger (2) zum Leiten des Kühlfluids ausgebildet ist.

8. Leistungsvorrichtung (100) nach einem der vorhergehenden Ansprüche, wobei
- die Leistungshalbleitermodule (1) jeweils mindestens einen Leistungshalbleiterchip (11) aufweisen, der eines von einem IGBT, einem MOSFET, einer Diode, einem Thyristor, einem JFET, einem HEMT ist.

9. Verfahren zum Zusammenfügen einer Leistungsvorrichtung (100), aufweisend:
- Montieren mindestens eines Leistungshalbleitermoduls (1) auf einer Oberseite (20) eines Trägers (2),
- Montieren mindestens eines Leistungshalbleitermoduls (1) auf einer Unterseite (21) des Trägers (2), die der Oberseite (20) gegenüberliegt, derart, dass
- mindestens zwei Leistungshalbleitermodule (1) in einer überlappenden Konfiguration angeordnet sind, wobei sich mindestens ein Leistungshalbleitermodul (1) auf der Oberseite (20) und mindestens ein Leistungshalbleitermodul (1) auf der Unterseite (21), wenn in Draufsicht auf die Oberseite (20) gesehen, zumindest teilweise überlappen, wobei
- die Leistungshalbleitermodule (1), die in der überlappenden Konfiguration angeordnet sind, jeweils ein Funktionsgebiet (12) und ein Hilfsgebiet (13) aufweisen,
- ein oder mehrere Leistungshalbleiterchips (11) in dem Funktionsgebiet (12) angeordnet sind, wobei sich die Hilfsgebiete (13) der Leistungshalbleitermodule (1) in der überlappenden Konfiguration in Draufsicht auf die Oberseite (20) zumindest teilweise überlappen und die Funktionsgebiete (12) in dieser Draufsicht überlappungsfrei zueinander sind, wobei
- die Leistungshalbleitermodule (1) jeweils mehrere Kühlelemente (10) an ihrer jeweiligen Rückseite aufweisen, wobei die Kühlelemente (10) in dem Funktionsgebiet (12) angeordnet sind,
- der Träger (2) mindestens eine obere Öffnung (22) an der Oberseite (20) und mindestens eine untere Öffnung (23) an der Unterseite (21) aufweist,
- sich die mindestens eine obere Öffnung (22) und die mindestens eine untere Öffnung (23), wenn in Draufsicht auf die Oberseite (20) gesehen, höchstens teilweise überlappen,
- die Kühlelemente (10) der Leistungshalbleitermodule (1) durch die obere Öffnung (22) und die untere Öffnung (23) in den Träger (2) vorragen,
- die Leistungshalbleiterchips (11) in einem Gehäuse des jeweiligen Leistungshalbleitermoduls (1) angeordnet sind, wobei das Gehäuse durch eine Kapselung (14) gebildet ist, der eine oder die mehreren Leistungshalbleiterchips (11) in der Kapselung (14) eingebettet sind,
- das Hilfsgebiet (13) frei von Leistungshalbleiterchips (11) ist,
- in den Hilfsgebieten (13) eine Rückseite der Leistungshalbleitermodule (1) durch ein Substrat oder eine Grundplatte gebildet ist und eine Vorderseite der Leistungshalbleitermodule (1) durch die Kapselung (14) gebildet ist,
- in den Hilfsgebieten (13) die Leistungshalbleitermodule (12) durch Befestigungsmittel an dem Träger (2) befestigt sind, wobei durch die Kapselung (14) Schraubenlöcher gebildet sind.

## Revendications

1. Dispositif de puissance (100) comprenant
- au moins deux modules semi-conducteurs de puissance (1),
- un support (2) ayant un côté supérieur (20) et un côté inférieur opposé (21), dans lequel
- les modules semi-conducteurs de puissance (1) sont montés sur le support (2) et sont thermiquement reliés au support (2),
- au moins deux modules semi-conducteurs de puissance (1) sont disposés en chevauchement de telle sorte qu'au moins un module semi-conducteur de puissance (1) monté sur le côté supérieur (20) et au moins un module semi-conducteur de puissance (1) monté sur le côté inférieur (21) se chevauchent au moins partiellement dans une vue de dessus du côté supérieur (20), dans lequel
- les modules semi-conducteurs de puissance (1) disposés en chevauchement comprennent chacun une zone fonctionnelle (12) et une zone auxiliaire (13),
- une ou plusieurs puces semi-conductrices de puissance (11) sont disposées dans la zone fonctionnelle (12), les zones auxiliaires (13) des modules semi-conducteurs de puissance (1), dans la configuration de chevauchement, se chevauchant au moins partiellement dans une vue de dessus du côté supérieur (20) et les zones fonctionnelles (12) ne se chevauchant pas dans cette vue de dessus, dans lequel
- les modules semi-conducteurs de puissance (1) comportent chacun, sur leur côté arrière respectif, plusieurs éléments de refroidissement (10), les éléments de refroidissement (10) étant disposés dans la zone fonctionnelle (12),
- le support (2) comporte au moins une ouverture supérieure (22) sur le côté supérieur (20) et au moins une ouverture inférieure (23) sur le côté inférieur (21),
- l'au moins une ouverture supérieure (22) et l'au moins une ouverture inférieure (23) se chevauchent au plus partiellement dans une vue de dessus du côté supérieur (20),
- les éléments de refroidissement (10) des modules semi-conducteurs de puissance (1) font saillie à travers l'ouverture supérieure (22) et l'ouverture inférieure (23) dans le support (2),
- les puces semi-conductrices de puissance (11) sont disposées dans un boîtier du module semi-conducteur de puissance (1) respectif, le boîtier étant formé par une encapsulation (14), la ou les puces semi-conductrices de puissance (11) sont noyées dans l'encapsulation (14),
- la zone auxiliaire (13) est exempte de puces semi-conductrices de puissance (11),
- dans les zones auxiliaires (13), un côté arrière des modules semi-conducteurs de puissance (1) est formé par un substrat ou une plaque de base et un côté avant des modules semi-conducteurs de puissance (1) est formé par l'encapsulation (14)
- dans les zones auxiliaires (13), les modules semi-conducteurs de puissance (12) sont fixés au support (2) par des moyens de fixation, des trous de vis étant formés à travers l'encapsulation (14).

2. Dispositif de puissance (100) selon la revendication 1,
- le dispositif de puissance (100) comprenant au moins trois modules semi-conducteurs de puissance (1) disposés en chevauchement de telle sorte que
- au moins deux modules semi-conducteurs de puissance (1) montés sur l'un des côtés supérieur (20) et inférieur (21) soient tous deux en chevauchement avec au moins un même module semi-conducteur de puissance (1) monté sur l'autre des côtés supérieur (20) et inférieur (21), dans une vue de dessus du côté supérieur (20).

3. Dispositif de puissance (100) selon l'une quelconque des revendications précédentes, dans lequel
- les éléments de refroidissement (10) sont des nervures de refroidissement ou des ailettes de refroidissement.

4. Dispositif de puissance (100) selon l'une quelconque des revendications précédentes, dans lequel
- les zones auxiliaires (13) des modules semi-conducteurs de puissance (1), dans la configuration de chevauchement, se chevauchent au moins partiellement dans une vue de dessus du côté supérieur (20) et les zones fonctionnelles (12) ne se chevauchent pas dans cette vue de dessus.

5. Dispositif de puissance (100) selon l'une quelconque des revendications précédentes, dans lequel
- le support (2) est configuré pour guider un fluide de refroidissement pour refroidir les modules semi-conducteurs de puissance (1).

6. Dispositif de puissance (100) selon la revendication 5 dans sa dépendance de la revendication 3, dans lequel
- le support (2) est conçu pour guider le fluide de refroidissement le long des éléments de refroidissement (10) faisant saillie à travers les ouvertures (22, 23).

7. Dispositif de puissance (100) selon la revendication 5 ou 6, dans lequel
- au moins un canal (25) est formé dans le support (2) pour guider le fluide de refroidissement.

8. Dispositif de puissance (100) selon l'une quelconque des revendications précédentes, dans lequel
- les modules semi-conducteurs de puissance (1) comprennent chacun au moins une puce semi-conductrice de puissance (11) qui est l'un des éléments suivants : un IGBT, un MOSFET, une diode, un thyristor, un JFET, un HEMT.

9. Procédé d'assemblage d'un dispositif de puissance (100), comprenant
- monter au moins un module semi-conducteur de puissance (1) sur un côté supérieur (20) d'un support (2),
- monter au moins un module semi-conducteur de puissance (1) sur un côté inférieur (21) du support (2) opposé au côté supérieur (20) de telle sorte que
- au moins deux modules semi-conducteurs de puissance (1) soient disposés en chevauchement, au moins un module semi-conducteur de puissance (1) sur le côté supérieur (20) et au moins un module semi-conducteur de puissance (1) sur le côté inférieur (21) se chevauchant au moins partiellement dans une vue de dessus du côté supérieur (20), dans lequel
- les modules semi-conducteurs de puissance (1) disposés en chevauchement comprennent chacun une zone fonctionnelle (12) et une zone auxiliaire (13),
- une ou plusieurs puces semi-conductrices de puissance (11) sont disposées dans la zone fonctionnelle (12), les zones auxiliaires (13) des modules semi-conducteurs de puissance (1), dans la configuration de chevauchement, se chevauchant au moins partiellement dans une vue de dessus du côté supérieur (20) et les zones fonctionnelles (12) ne se chevauchant pas dans cette vue de dessus, dans lequel
- les modules semi-conducteurs de puissance (1) comportent chacun, sur leur côté arrière respectif, plusieurs éléments de refroidissement (10), les éléments de refroidissement (10) étant disposés dans la zone fonctionnelle (12),
- le support (2) comporte au moins une ouverture supérieure (22) sur le côté supérieur (20) et au moins une ouverture inférieure (23) sur le côté inférieur (21),
- l'au moins une ouverture supérieure (22) et l'au moins une ouverture inférieure (23) se chevauchent au plus partiellement dans une vue de dessus du côté supérieur (20),
- les éléments de refroidissement (10) des modules semi-conducteurs de puissance (1) font saillie à travers l'ouverture supérieure (22) et l'ouverture inférieure (23) dans le support (2),
- les puces semi-conductrices de puissance (11) sont disposées dans un boîtier du module semi-conducteur de puissance (1) respectif, le boîtier étant formé par une encapsulation (14), la ou les puces semi-conductrices de puissance (11) sont noyées dans l'encapsulation (14)
- la zone auxiliaire (13) est exempte de puces semi-conductrices de puissance (11),
- dans les zones auxiliaires (13), un côté arrière des modules semi-conducteurs de puissance (1) est formé par un substrat ou une plaque de base et un côté avant des modules semi-conducteurs de puissance (1) est formé par l'encapsulation (14)
- dans les zones auxiliaires (13), les modules semi-conducteurs de puissance (12) sont fixés au support (2) par des moyens de fixation, des trous de vis étant formés à travers l'encapsulation (14).
